# EUROPÄISCHE PATENTANMELDUNG

(11) **EP 0 959 361 A2**
(43) Veröffentlichungstag der Anmeldung: **24.11.1999**
(21) Anmeldenummer: 99108198.5
(22) Anmeldetag: 27.04.1999
(51) Int. Cl.: G01R 31/08

(54) **Verfahren und Vorrichtung zur Erkennung und Überprüfung eines IT-Netzes**

(30) Priorität: 20.05.1998 DE 19822808
(71) Anmelder: GOSSEN-METRAWATT Gesellschaft mit beschränkter Haftung, D-90471 Nürnberg (DE)
(72) Erfinder: Krien, Burkhard Dipl.-Ing., 91154 Roth (DE)
(74) Vertreter: Hafner, Dieter, Dr.rer.nat., Dipl.-Phys.

(57) **Zusammenfassung**

Die Erfindung betrifft ein Verfahren zur Überprüfung eines IT-Netzes, wobei zunächst eine Überprüfung erfolgt, ob eine Gleichspannung zwischen mindestens einer Phase und dem Schutzleiter des IT-Netzes vorliegt und, falls dies der Fall ist, eine Überprüfung des IT-Netzes in Anlehnung an die Norm EN 60 950 erfolgt. Ferner betrifft die Erfindung eine Vorrichtung zur Überprüfung eines IT-Netzes mit mindestens einem Strommeßgerät 3 zur Ermittlung eines Schutzleiterableitstroms, Gehäuseableitstroms und/oder Patientenableitstroms eines Prüfobjekts, wobei ein Spannungsmeßgerät 4 vorgesehen ist, wodurch festgestellt wird, ob eine Gleichspannung zwischen mindestens einer Phase und dem Schutzleiter des IT-Netzes vorliegt.

## Beschreibung

Die Erfindung betrifft ein Verfahren zur Erkennung und Überprüfung eines IT-Netzes. Ferner betrifft die Erfindung eine Vorrichtung zur Erkennung und Überprüfung eines IT-Netzes mit mindestens einem Strommeßgerät zur Feststellung eines Schutzleiterableitstroms, Gerätestroms und/oder Patientenableitstroms eines Prüfobjekts.

Als Stand der Technik ist aus der Norm EN 60 950 ein Verfahren zur Überprüfung eines IT-Netzes bekannt, bei dem der Normalleiter und die einzelnen Phasen des IT-Netzes über ein Strommeßgerät mit Erde verbunden sind. Die gemessenen Ströme dürfen bei einem funktionssicheren Zustand des IT-Netzes vorgegebene Grenzwerte nicht übersteigen. Falls das Meßverfahren nach der Norm EN 60 950 irrtümlicherweise in einem TN- oder TT-Netz betrieben wird, kann eine Gefährdung des Benutzers auftreten.

Der Erfindung liegt die Aufgabe zugrunde, ein Verfahren sowie eine Vorrichtung zur Überprüfung eines IT-Netzes anzubieten, bei denen auch bei einer Falschbenutzung in einem Nicht-IT-Netz keine Gefahren für den Benutzer auftreten.

Die Aufgabe wird für das Verfahren durch die Merkmale des kennzeichnenden Teils des Patentanspruchs 1 gelöst. Vorteilhafte Verfahrensvarianten werden durch die Unteransprüche 2 - 6 realisiert. Für die Vorrichtung wird die Aufgabe durch die Merkmale des kennzeichnenden Teils des Patentanspruchs 7 in Verbindung mit dem Oberbegriff gelöst. Vorteilhafte Ausführungsformen der Vorrichtung werden durch die weiteren Unteransprüche 8 - 14 realisiert.

Beim erfindungsgemäßen Verfahren wird vorgeschlagen, vor der Durchführung eines Prüfverfahrens in Anlehnung an die Norm EN 60 950 zu überprüfen, ob eine Gleichspannung zwischen mindestens einer Phase und dem Schutzleiter des IT-Netzes vorliegt. Hierdurch kann festgestellt werden, ob das Verfahren auch tatsächlich an einem IT-Netz durchgeführt wird oder ob irrtümlicherweise mit der Überprüfung eines TN- oder TT-Netzes begonnen wurde. Damit wird eine Gefährdung des Benutzers durch ein unbeabsichtigtes Durchführen des Überprüfungsverfahrens an einem TN- oder TT-Netz zuverlässig vermieden.

Bei der Feststellung der Gleichspannung kann auch ermittelt werden, ob der festgestellte Gleichspannungswert sich in einem bestimmten Bereich (z.B. 10 V - 48 V) befindet. Bei der IT-Netzerkennung kann die Gleichspannung zwischen einer Phase und dem PE-Leiter (Schutzleiter) festgestellt werden. Insbesondere dann, wenn die Prüfvorrichtung zur Durchführung des Überprüfungsverfahrens einen Transformator als eigene Versorgungseinheit aufweist, kann vor allem bei einem Zwei-Phasen-IT-Netz eine 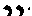 Mittelanzapfung" des Transformators erfolgen, welche über ein Spannungsmeßgerät zur Feststellung der Gleichspannung mit dem PE-Leiter verbunden ist.

Zur Sicherheitsüberwachung eines IT-Netzes ist üblicherweise in der Energieversorgung des IT-Netzes ein Überwachungssystem (z.B. sog. 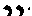 Isolationswächter") vorgesehen, welches z.B. bei IT-Netzen in Operationssälen oder Krankenhäusern mit einer Zentralstelle verbunden ist.

Um bei einer Überprüfung lokaler IT-Netze in einzelnen Operationssälen durch das erfindungsgemäße Prüfungsverfahren ein Ansprechen der Überwachungssysteme zu vermeiden, erfolgt die Erkennung des IT-Netzes durch Feststellung der Gleichspannung über einen besonders hochohmigen Widerstand, um möglichst geringe zusätzliche Ströme im IT-Netz zu erzeugen und die Überwachungssysteme in der Energieversorgung nicht ansprechen zu lassen.

Vorteilhafterweise wird in einer weiteren Verfahrensvariante die Schutzleiterverbindung zwischen Energieversorgung und Prüfobjekt, welche die Prüfvorrichtung durchläuft, unterbrochen, um etwaige Verfälschungen der Ableitströme aufgrund der Streuinduktivität des Transformators auszuschalten.

Nachdem festgestellt wurde, daß ein funktionsfähiges und gesichertes IT-Netz vorliegt, kann das IT-Netz in Anlehnung an die Norm EN 60 950 überprüft werden. Dabei können unter Berücksichtigung sämtlicher Schalter- und Betriebszustände des Prüfobjekts die Schutzleiterableitströme der einzelnen Phasen des IT-Netzes über den Schutzleiter ermittelt und mit einem vorgegebenen Grenzwert verglichen werden. Über ein weiteres Strommeßgerät kann parallel zur ersten Strommessung auch der Gehäuseableitstrom des Prüfobjekts festgestellt werden.

Insbesondere bei einer Anwendung von IT-Netzen in Krankenhäusern und Operationssälen kann auch der Patientenableitstrom ermittelt werden, der z.B. bei mit dem Patienten in Verbindung stehenden medizinischen Geräten (z.B. Sonden, EKG, EEG, etc.) auftreten kann.

Die erfindungsgemäße Vorrichtung weist ein Spannungsmeßgerät auf, über welches das Vorliegen von Gleichspannungen zwischen mindestens einer Phase und dem PE-Leiter des IT-Netzes festgestellt werden kann. Dadurch kann ermittelt werden, ob ein gesichertes IT-Netz vorliegt.

Die tatsächliche Überprüfung des IT-Netzes in Anlehnung an die Norm EN 60 950 erfolgt erst dann, wenn zweifelsfrei festgestellt wurde, ob ein IT-Netz vorliegt.

Die erfindungsgemäße Prüfvorrichtung kann eine eigene Versorgungseinheit, z.B. ein Transformator, aufweisen. Insbesondere dann, wenn das IT-Netz zwei Phasen (L1 und L2) aufweist, können diese mit der Sekundärseite des Versorgungstransformators verbunden sein und kann durch eine Mittelanzapfung der Sekundärseite des Transformators über ein Spannungsmeßgerät die Verbindung mit dem Schutzleiter hergestellt werden. Damit wird auch bei einem nicht-symmetrischen IT-Netz ein aussagefähiger Gleichspannungswert zur Beurteilung des Vorliegens eines IT-Netzes ermittelt.

In der erfindungsgemäßen Prüfvorrichtung ist vorteilhafterweise die Schutzleiterverbindung zwischen Energieversorgung und Prüfobjekt unterbrochen. Hierdurch werden etwaige verzerrende Einflüsse z.B. durch die Streuinduktivität des Transformators der Energieversorgung auf die tatsächliche Messung der Ableitströme vermieden.

Die Prüfvorrichtung weist vorteilhaflerweise mehrere Umschalter auf, um Verbindungen mit den einzelnen Phasen des IT-Netzes, dem Gehäuse des Prüfobjekts und/oder bei einer Anwendung im Krankenhausbereich dem Patienten herzustellen. Hierdurch können sämtliche in der jeweiligen Situation erforderlichen Überprüfungsmaßnahmen und Ableitstrommessungen am IT-Netz durchgeführt werden.

Vorteilhafterweise umfaßt die Prüfvorrichtung mehrere Strommeßgeräte, welche parallel verschiedene Arten von Ableitströmen, z.B. Schutzleiterableitströmen und/oder Gehäuseableitströmen des Prüfobjekts ermitteln.

Die Gleichspannungsmessung zur Erkennung des IT-Netzes erfolgt vorteilhafterweise besonders hochohmig, um einen möglichst geringen Strom in das IT-Netz einzuspeisen und die in der Energieversorgung vorgesehenen Überwachungssysteme ( 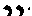 Isolationswächter") während der Überprüfung des IT-Netzes nicht ansprechen zu lassen. Der Widerstand im Spannungsmeßgerät der Prüfvorrichtung kann an die Ansprechempfindlichkeit und die sonstigen elektrischen Kenndaten der Überwachungssysteme in der Energieversorgung des IT-Netzes angepaßt werden.

Die Erfindung ist anhand eines Ausführungsbeispiels in der Zeichnungsfigur näher erläutert.

Zur Überprüfung des IT-Netzes wird die Prüfvorrichtung 9 zwischen die Energieversorgung 1 und das Prüfobjekt 2 geschaltet. In der Energieversorgung 1 wird das primärseitige TN-Netz des Transformators 15 in ein sekundärseitiges IT-Netz überführt. Als Überwachungssystem ist ein zentraler Isolationswächter 10 vorgesehen, der z.B. zur Überwachung eines IT-Gesamtnetzes (z.B. in mehreren Operationssälen eines Krankenhauses) dient.

Das abgebildete IT-Netz weist die beiden Phasen L1 und L2 sowie den Schutzleiter PE auf. Beim Anschluß der Prüfvorrichtung 9 zwischen der Energieversorgung 1 und dem Prüfobjekt 2 ist der Unterbrecher 6 geöffnet, so daß keine Verbindung des Schutzleiters PE zwischen Energieversorgung 1 und dem Prüfobjekt 2 besteht.

Zu Beginn des erfindungsgemäßen Verfahrens wird über das Spannungsmeßgerät 4 festgestellt, ob eine Gleichspannung zwischen dem Schutzleiter PE und den Phasen L1 und L2 vorliegt. Die Phasen L1 und L2 sind an die Sekundärseite der als Transformator ausgeführten Versorgungseinheit 5 angeschlossen. Über die Mittelanzapfung 16 auf der Sekundärseite der Versorgungseinheit 5 wird die Gleichspannung im Spannungsmeßgerät 4 ermittelt. Damit wird auch ein aussagekräftiger Gleichspannungswert bei einem nicht-symmetrischen Netzzustand in den einzelnen Phasen L1 und L2 festgestellt.

Nachdem über das Spannungsmeßgerät 4 festgestellt wurde, daß eine Gleichspannung vorliegt, die sich auch noch in einem vorgebbaren Bereich (z.B. 10 V - 48 V) befindet, wird davon ausgegangen, daß ein IT-Netz vorliegt, so daß die weiteren Messungen in Anlehnung an die Norm EN 60 950 ohne Gefährdung des Benutzers auch ohne Trenntrafo durchgeführt werden können.

Dabei wird zunächst bei einer Stellung des Umschalters 7 in der abgebildeten Position ein etwaiger Schutzleiterableitstrom zwischen der Phase L1 und dem Schutzleiter PE festgestellt. Danach wird nach Umstellung des Umschalters 7 ein etwaiger Schutzleiterableitstrom zwischen der Phase L2 und dem Schutzleiter PE festgestellt. Das Strommeßgerät 3 zeigt jeweils die ermittelten Strommeßwerte an, welche mit vorgegebenen Grenzwerten verglichen werden.

Bei der Überprüfung der Schutzleiterableitströme zwischen Schutzleiter PE und den einzelnen Phasen des IT-Netzes ist der SFC-Schalter (single-fault-condition) 14 geschlossen.

Über das Strommeßgerät 3' kann bei der abgebildeten Stellung des Umschalters 7' über den Patientenanschluß 12 und die Patientensehnittstelle 13, insbesondere bei IT-Netzen in Krankenhäusern, festgestellt werden, ob bei bestimmten Krankenhausvorrichtungen, die in direkten Kontakt mit dem Patienten stehen (z.B. Sonden, EKG, EEG etc.), aufgrund fehlerhafter Isolierungen unerwünschte Patientenableitströme auftreten.

Bei einer Umstellung des Umschalters 7' kann über das Strommeßgerät 3' festgestellt werden, ob über den Gehäuseanschluß 11 ein Gehäuseableitstrom des Prüfobjekts 2 vorliegt. Die Messungen in den Strommeßgeräten 3, 3' können parallel durchgeführt werden. Es kann aber auch der SFC-Schalter 14 geöffnet werden, um eine unabhängige Messung der Gehäuseableitströme und/oder Patientableitenströme zu erzielen.

### BEZUGSZEICHEN

- 1: Energieversorgung
- 2: Prüfobjekt
- 3, 3': Strommeßgerät
- 4: Spannungsmeßgerät
- 5: Versorgungseinheit
- 6: Unterbrecher
- 7, 7': Umschalter
- 8: Gehäuse
- 9: Prüfvorrichtung
- 10: Isolationswächter
- 11: Gehäuseanschluß
- 12: Patientenanschluß
- 13: Patientenschnittstelle
- 14: SFC-Schalter
- 15: Transformator
- 16: Mittelanzapfung
- PE: Schutzleiter
- N: Normalleiter
- L: Phase
- TN: TN-Netz
- IT: IT-Netz

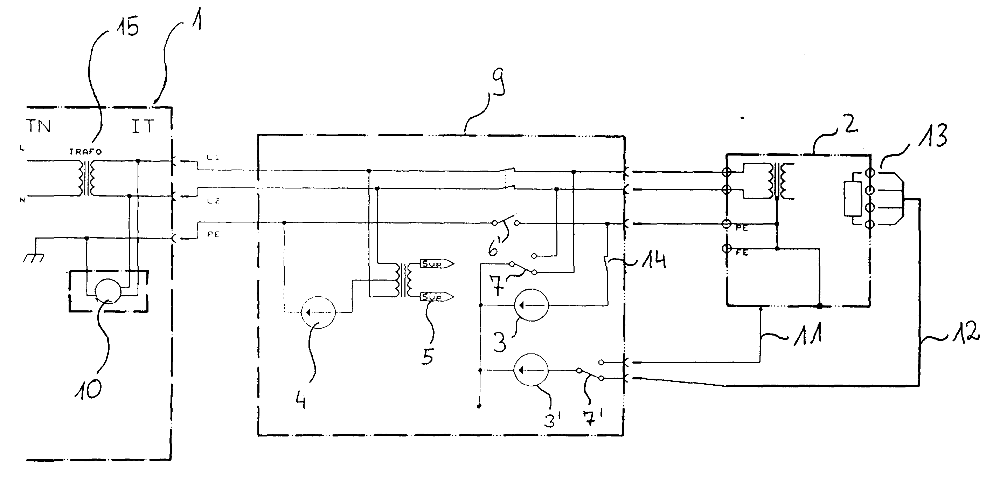

## Patentansprüche

1. Verfahren zur Erkennung und Überprüfung eines IT-Netzes,
**gekennzeichnet durch**
**folgende Verfahrensschritte:**
a) Überprüfung, ob eine Gleichspannung zwischen mindestens einer Phase und dem Schutzleiter des IT-Netzes vorliegt, und, falls dies der Fall ist,
b) Überprüfung des IT-Netzes durch ein Prüfverfahren in Anlehnung an die Norm EN 60 950.

2. Verfahren nach Anspruch 1,
**dadurch gekennzeichnet, daß**
überprüft wird, ob eine Gleichspannung zwischen dem Schutzleiter und mehreren Phasen vorliegt.

3. Verfahren nach Anspruch 1 oder 2,
**dadurch gekennzeichnet, daß**
über einen hochohmigen Widerstand festgestellt wird, ob eine Gleichspannung zwischen dem Schutzleiter und mindestens einer Phase des IT-Netzes vorliegt.

4. Verfahren nach einem der Ansprüche 1 - 3,
**dadurch gekennzeichnet, daß**
die Schutzleiterverbindung zwischen Energieversorgung und Prüfobjekt unterbrochen wird.

5. Verfahren nach einem der Ansprüche 1 - 4.
**dadurch gekennzeichnet, daß**
im Rahmen der Überprüfung des IT-Netzes in Anlehnung an die Norm EN 60 950 der Schutzleiterableitstrom einer oder mehrerer Phasen des Prüfobjekts ermittelt und mit einem vorgegebenen Grenzwert verglichen wird.

6. Verfahren nach einem der Ansprüche 1 - 5,
**dadurch gekennzeichnet, daß**
im Rahmen der Überprüfung des IT-Netzes in Anlehnung an die Norm EN 60 950 der Gehäuseableitstrom und/oder Patientenableitstrom des Prüfobjekts ermittelt und mit einem vorgegebenen Grenzwert verglichen wird.

7. Vorrichtung zur Überprüfung eines IT-Netzes mit mindestens einem Strommeßgerät zur Ermittlung eines Schutzleiterableitstroms, Gerätestroms und/oder Patientenableitstroms eines Prüfobjekts, insbesondere zur Durchführung eines Verfahrens nach einem der Ansprüche 1 - 6,
**dadurch gekennzeichnet, daß**
ein Spannungsmeßgerät (4) vorgesehen ist, um festzustellen, ob eine Gleichspannung zwischen mindestens einer Phase und dem Schutzleiter des IT-Netzes vorliegt.

8. Vorrichtung nach Anspruch 7,
**dadurch gekennzeichnet, daß**
eine mit dem Spannungsmeßgerät (4) verbundene Versorgungseinheit (5), insbesondere ein Transformator, vorgesehen ist.

9. Vorrichtung nach Anspruch 8,
**dadurch gekennzeichnet, daß**
am Transformator ein Mittelabgriff erfolgt, um eine Gleichspannung zwischen dem Schutzleiter und mehreren Phasen des IT-Netzes zu ermitteln.

10. Vorrichtung nach einem der Ansprüche 7 - 9,
**dadurch gekennzeichnet, daß**
ein Unterbrecher (6) zur Unterbrechung des Schutzleiters PE vorgesehen ist.

11. Vorrichtung nach einem der Ansprüche 7 - 10,
**dadurch gekennzeichnet, daß**
ein Umschalter (7) vorgesehen ist, um dem Strommeßgerät (3) verschiedene Phasen zuzuschalten.

12. Vorrichtung nach einem der Ansprüche 7 - 11,
**dadurch gekennzeichnet, daß**
ein weiteres Strommeßgerät (3') vorgesehen ist.

13. Vorrichtung nach Anspruch 12,
**dadurch gekennzeichnet, daß**
das weitere Strommeßgerät (3') über einen weiteren Umschalter (7') mit dem Gehäuse (8) des Prüfobjekts (9) und einer Patientenschnittstelle (13') verbunden ist.

14. Vorrichtung nach einem der Ansprüche 7 - 13,
**dadurch gekennzeichnet, daß**
das Spannungsmeßgerät (4) einen besonders hochohmigen Widerstand aufweist.
